# EUROPEAN PATENT APPLICATION

(11) **EP 1 965 421 A2**
(43) Date of publication of application: **03.09.2008**
(21) Application number: 08001425.1
(22) Date of filing: 25.01.2008
(51) Int. Cl.: H01L 21/60, H01L 23/31, H01L 23/538

(54) **Wiring structure, forming method of the same and printed wiring board**

(30) Priority: 28.02.2007 JP 2007050490
(71) Applicant: TDK Corporation, Tokyo 103-8272 (JP)
(72) Inventor: Nagase, Kenji, Tokyo 103-8272 (JP); Kawabata, Kenichi, Tokyo 103-8272 (JP)
(74) Representative: Grünecker, Kinkeldey, Stockmair & Schwanhäusser Anwaltssozietät

(57) **Abstract**

There is disclosed a wiring structure or the like capable of sufficiently improving a connection property between a body to be wired and a wiring pattern (layer) connected to the body to be wired. In a semiconductor-embedded substrate 1, conductive patterns 13 are formed on opposite surfaces of a core substrate 11, and a semiconductor device 14 is arranged in a resin layer 16 laminated on the core substrate 11. The resin layer 16 is provided with the conductive pattern 13 and bumps 14p of the semiconductor device 14, and via-holes 19a, 19b are formed through upper portions of the resin layer. In the via-holes 19a, 19b, via-hole electrode portions 23a, 23b are connected to the conductive pattern 13 and the bumps 14p of the semiconductor device 14. The via-hole electrode portions 23a, 23b are provided so that each via-hole electrode portion has a concave portion at an upper surface thereof and so that a side wall thereof including an edge portion of the concave portion does not come in contact with an inner wall of the via-hole 19a or 19b.

## Description

### BACKGROUND OF THE INVENTION

The present invention relates to a wiring structure in a multilayer printed wiring board, a component-embedded printed wiring board and the like.

As a highly dense mounting structure of electronic components such as semiconductor IC chips, there are known a multilayer printed board in which an insulating layer and a wiring layer are alternately laminated, and a component-embedded printed board having an insulating layer in which electronic components are embedded. In the printed wiring board having such a structure, as a method for connecting a wiring layer to bodies to be wired such as a lower wiring layer arranged in a lower portion and an inner portion of the insulating layer, electrodes of the embedded electronic components and bumps, a method is known in which a connection hole referred to as a via-hole is formed through the insulating layer to expose the bodies to be wired, and the bodies to be wired are connected to the wiring layer in this via-hole (see Japanese Patent Application Laid-Open No. 2006-100773 and Japanese Patent Application Laid-Open No. 2005-64470).

In addition, generally, as a forming method of a wire, there are known an additive process of selectively forming the wiring layer formed on a wiring pattern portion; a semi-additive process of forming an underlayer on the whole surface of a substrate, then selectively removing or masking a portion of the underlayer other than the wiring pattern thereof, and forming the wiring layer on the underlayer remained in the form of the pattern or exposed; a subtractive process of forming a conductive layer on the whole surface of the substrate, and then selectively removing a portion of the conducive layer other than the wiring pattern portion thereof to form the wiring layer; and the like. Moreover, even in via-hole connection for connecting the bodies to be wired to the wiring layer in the via-hole, these wire forming methods are employed in many cases.

For example, Japanese Patent Application Laid-Open No. 2006-100773 discloses a method (the subtractive process) for forming a conductive layer on the whole surface of a substrate including an inner wall of a via-hole in the multilayer printed wiring board, and then selectively removing a portion of the conductive layer other than a wiring pattern portion thereof by photolithography and etching to form the wiring pattern.

Moreover, Japanese Patent Application Laid-Open No. 2005-64470 discloses a method (the semi-additive process) for forming a conductive underlayer on the whole surface of a substrate including an inner wall of a via-hole in the component-embedded printed wiring board, then masking a portion of the conductive underlayer other than the wiring pattern portion thereof, and performing electric plating or the like on the exposed conductive underlayer as a base to form a wiring pattern.

In addition, as a result of detailed investigation on the above-mentioned conventional wiring pattern (layer), the present inventors has found that the bodies to be wired such as the lower wiring layer, the electrodes and the bumps are made of the same type of metal as that of the wiring layer, and metal coupling occurs in an interface between them, but the connection between them might be insufficient. In such a case, it becomes difficult to maintain sufficiently high reliability of the wiring board, a device or the like having such a wiring structure.

### SUMMARY OF THE INVENTION

The present invention has been developed in view of such a situation, and an object thereof is to provide a wiring structure capable of sufficiently improving a connection property between a body to be wired and a wiring pattern (layer) connected to the member, a manufacturing method of the wiring structure, and a printed wiring board having the wiring structure.

To solve the above problems, as a result of intensive investigation on a wiring structure in which the wiring layer is connected to the body to be wired in a via-hole, the present inventors have found that in the conventional wiring layer, a stress which functions so as to move the wiring layer from the body to be wired can be applied to an inner portion of the wiring layer in a connection interface area between the wiring layer and the body to be wired during heating and cooling treatments in manufacturing steps and inspection steps and that a degree of the inner stress is influenced by a shape parameter of the wiring layer, and the present inventors have completed the present invention.

That is, a wiring structure according to the present invention comprises an insulating layer provided with a connection hole; a body to be wired which is arranged so that at least a part of the body to be wired is exposed to a bottom portion of the connection hole; and a wiring layer connected to the body to be wired in the connection hole, having a concave portion in at least a part of an upper surface thereof, and provided so that a side wall thereof including an edge portion of the concave portion does not come in contact with an inner wall of the connection hole.

Here, the "insulating layer" of the present invention is a layer constituted of an electrically insulating material, and examples of the insulating layer include an insulating interlayer of a multilayer printed wiring board and a component-embedded layer of a component-embedded printed wiring board. Moreover, the "body to be wired" is a target to be wired by the wiring layer. In other words, it is a target to be connected to a wire. Examples of the member include a lower wiring layer of the multilayer printed wiring board and an electrode of an embedded electronic component of the component-embedded printed wiring board. Furthermore, the "wiring layer" is a layer constituting a wiring pattern for connecting the body to be wired to another component mounted on the printed wiring board or the like. Furthermore, the "inner wall" of the connection hole is a side wall in a case where the connection hole can clearly separate a side wall and a bottom wall as in, for example, a cup shape (a cylindrical shape whose one end is blocked), and is mainly a wall portion other than a portion corresponding to a bottom portion in a case where the side wall and the bottom wall cannot clearly be distinguished.

In the wiring structure having such a constitution, the body to be wired which is exposed to the bottom portion of the connection hole formed through the insulating layer is connected to the wiring layer to form the wiring structure, the wiring layer has the concave portion in at least a part of the upper surface thereof (e.g., a simple trapezoidal shape is not formed, and the upper surface is formed into a sectional shape of a recessed mortar-like upper surface). Furthermore, the wiring layer is formed so that a side wall including the edge portion of the concave portion, that is, at least a part of the side wall of an upper end of the wiring layer does not come in contact with the inner wall of the connection hole.

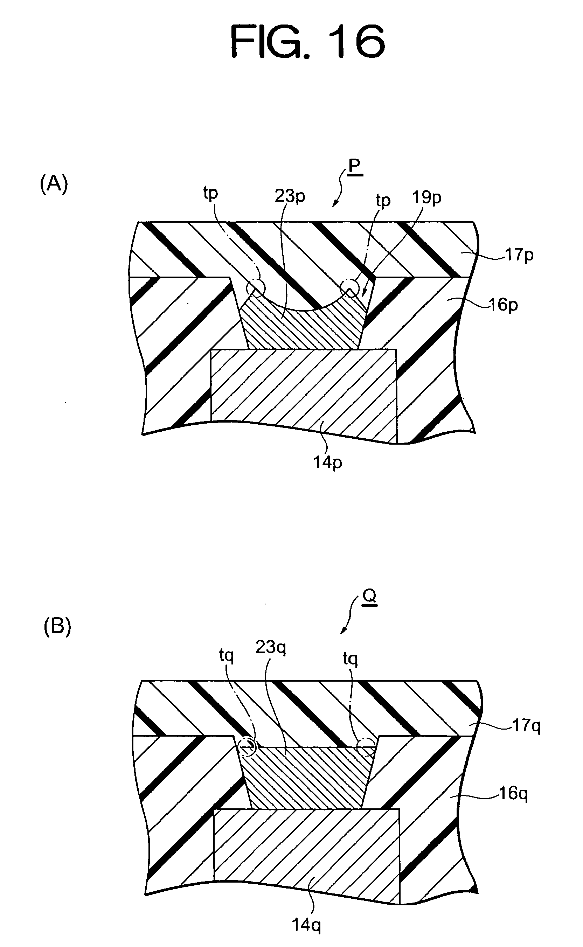

Here, FIGS. 16A and 16B are schematic sectional views schematically showing a wiring structure according to the present invention in which the upper surface of the wiring layer has the concave portion and a wiring structure in which the upper surface of the wiring layer is flat, respectively. In a wiring structure P shown in FIG. 16A, a semiconductor device (not shown) is disposed in a resin layer 16p provided on a base (not shown), and a via-hole 19p is formed above a bump 14p (a body to be wired) of the semiconductor device. In the via-hole 19p, the bump 14p is connected to a via-hole electrode portion 23p (a wiring layer) whose upper surface is formed into a concave shape and in which a void is defined between them so that a side wall upper portion (a side wall including upper ends tp) does not come in contact with an inner wall of the via-hole 19p, and a resin layer 17p is provided above the bump. On the other hand, a wiring structure Q shown in FIG. 16B is formed in the same manner as in the wiring structure P except that the structure includes a via-hole electrode portion 23q having a flat upper surface and having the whole side wall that comes in contact with an inner wall of the via-hole. It is to be noted that in FIG. 16B, other components are denoted with reference numerals each having affix "q".

When these wiring structures P, Q are subjected to heating and cooling treatments in the manufacturing steps and the inspection steps, the via-hole electrode portions 23p, 23q expand and contract, whereby thermal stresses are applied to peripheral portions and inner portions of the via-hole electrode portions including the upper ends tp, tq, respectively. Especially, in interface areas between the via-hole electrode portions 23p, 23q and the bumps 14p, 14q, such stresses as to move the via-hole electrode portions 23p, 23q might be generated in the bumps 14p, 14q, respectively, owing to differences of a thermal expansion ratio and a thermal contraction ratio between them. Such a degree of stress (thermal strain) tends to be especially remarkable in a case where the bumps 14p, 14q as the bodies to be wired are subjected to the heating and cooling treatments prior to the forming of the via-hole electrode portions 23p, 23q, respectively.

At this time, in the wiring structure P according to the present invention shown in FIG. 16A, the upper ends tp including a peripheral edge (an edge portion) of the concave portion do not come in contact with the via-hole 19p, and are formed into a steeple-like sectional shape, so that a stress tends to be concentrated more easily on the upper ends than the inner portion of the via-hole electrode portion 23p. However, the upper surface of the via-hole electrode portion 23p is provided with the concave portion and recessed, whereby such a stress is relaxed so as to be so-called absorbed in the concave portion. That is, the upper ends tp of the via-hole electrode portion 23p including the edge portion of the concave portion do not come in contact with the via-hole 19p, and the upper surface thereof has the concave portion, so that the thermal stress generated in the via-hole electrode portion 23p is relaxed in the concave portion to reduce the stress which functions so as to move (peel) the via-hole electrode portion 23p from the bump 14p in the interface area between the via-hole electrode portion 23p and the bump 14p.

On the other hand, in the wiring structure Q shown in FIG. 16B, the upper surface of the via-hole electrode portion 23q is flat and the whole side wall thereof comes in contact with the inner wall of the via-hole, so that the inner stress generated in the via-hole electrode portion 23q does not so-called escape, and the wiring structure has a small function of relaxing the thermal stress as compared with the wiring structure P. Therefore, it is not easy to reduce the stress which functions so as to move (peel) the via-hole electrode portion 23q from the bump 14q in the interface area between the via-hole electrode portion 23q and the bump 14q. In the wiring structure Q, the whole side wall comes in contact with the inner wall of the via-hole, so that a volume of the via-hole electrode portion 23q is larger than that of the via-hole electrode portion 23p, and the generated stress itself is larger than the stress generated in the via-hole electrode portion 23p.

As a result, in the wiring structure Q, the stress continues to be applied in a direction in which the via-hole electrode portion 23q moves from the bump 14q in the contact interface area between the bump 14q and the via-hole electrode portion 23q, whereby a connection property between the via-hole electrode portion 23q and the bump 14q might lower. On the other hand, in the wiring structure P, such a stress is reduced, whereby the connection property between them is improved, and held with an elapse of time. However, the function is not limited to the above-mentioned function.

Furthermore, the wiring layer has the concave portion in at least a part of the upper surface thereof, and hence a surface area enlarges as compared with a case where the upper surface of the wiring layer is flat. Therefore, when an upper portion of the wiring layer is covered with an upper structure of a resin or the like, a contact area between the upper structure of the resin and the wiring layer increases, and hence a bonding property between them improves. Furthermore, at least a part of the upper surface of the wiring layer has the concave portion to form a recess, so that the edge portion of the concave portion (the recess) is disposed so as to protrude into the upper structure of the resin or the like of the upper layer of the edge portion, and the bonding property between them (a fixing force of the resin or the like) is further improved by a so-called anchor effect. This can easily be understood from the example shown in FIG. 16A in which the upper ends tp of the via-hole electrode portion 23p form a steeple-like shape, and are disposed so as to cut into (as if an anchor were to be driven) the resin layer 17p formed on the upper ends.

In addition, it is preferable that the wiring layer includes a portion in which a sectional area increases from the edge portion of the concave portion toward the body to be wired. It is to be noted that in the present invention, the "sectional area" of the wiring layer is a sectional area in a plane parallel to the surface defined by an opening end of the connection hole. In this case, the wiring layer is formed into a shape including, for example, a portion in which a sectional area (it may be regarded as a volume or a section width) gradually increases. The shape broadens toward the bottom portion of the connection hole (e.g., a mountain-like shape, a trapezoidal shape or a conical shape, with the proviso that a side wall surface thereof does not have to be a smooth surface). In other words, the wiring layer is formed into a shape including a portion tapered toward the opening end of the connection hole.

In this case, it becomes easy to form, for example, the upper ends tp having the steeple-like sectional shape as in the via-hole electrode portion 23p shown in FIG. 16A, and the upper ends together with the concave portion formed at the upper surface of the via-hole electrode portion 23p improve a function of relaxing the stress applied to the via-hole electrode portion 23p.

Furthermore, it is preferable that the wiring layer includes a portion in which a sectional area increases from a portion connected to the body to be wired toward an opening of the connection hole. Specific examples of such a constitution include a structure where as in the wiring structure P described above and shown in FIG. 16A, a diameter of the via-hole 19p as the connection hole is gradually increased from the bottom portion thereof toward the opening, and the via-hole electrode portion 23p as the wiring layer is formed so as to fill in the bottom portion of the via-hole 19p. According to such a constitution, the stress applied to the interface area between the via-hole electrode portion 23p and the bump 14p as the body to be wired is diffused along the bottom portion side wall (i.e., the inner wall of the bottom portion of the via-hole 19p) of the via-hole electrode portion 23p, and the inner stress of the via-hole electrode portion 23p can further be relaxed. However, the function is not limited to this function.

In addition, it is more preferable that the wiring layer is provided so as to define a spatial area where at least a part of the inner wall of the connection hole does not come in contact with the wiring layer. Examples of such a structure include a wiring structure provided with the defined spatial area where the inner wall of the via-hole 19p as the connection hole does not come in contact with the via-hole electrode portion 23p as the wiring layer as shown in FIG. 16A.

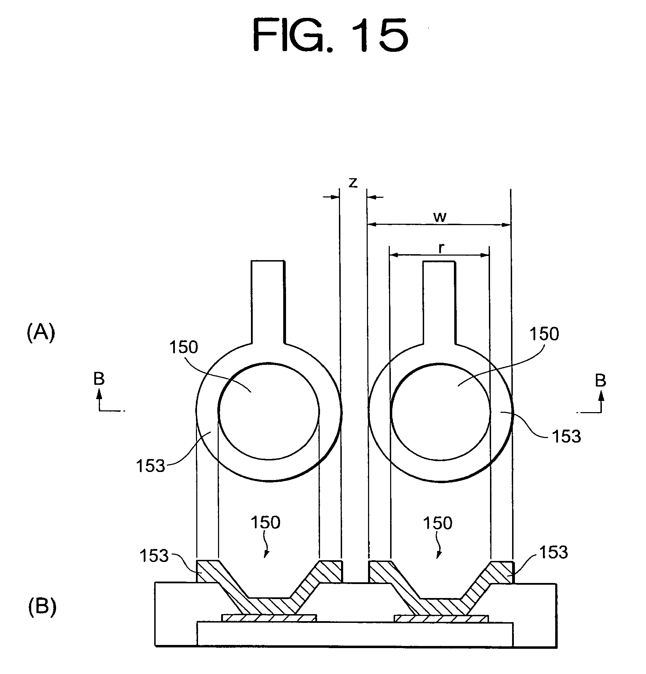

Here, in the above conventional wire forming method, when the wiring layer is patterned, a positional deviation might occur. Therefore, to allow such a positional deviation and securely connect the wiring layer, a wiring structure tends to be employed in which the wiring layer is extended from an outer side of an upper portion of the via-hole to the surface of the insulating layer. That is, as shown in FIGS. 15A and 15B, conventional via-hole connection tends to be designed so that a width w of a wiring layer 153 formed above a via-hole 150 is larger than an opening diameter r of the via-hole 150.

In this case, as shown in the drawing, an insulating distance z between adjacent wiring layers is the shortest distance between portions of the wiring layers extending along the surface of an insulating layer. To secure a sufficient insulating distance z, an interval between via-holes (a via-hole pitch) has to be broadened to a certain degree. Therefore, in an actual condition, there is a restriction on high densification of a printed wiring board due to narrowing of an arrangement interval between the bodies to be wired involving reduction of the pitch between the via-holes.

Moreover, to realize highly dense mounting, it is supposed that a wire itself is thinned and that the pitch between the wiring patterns is reduced to secure the wire interval (the insulating distance), but when the positional deviation between the body to be wired and the wiring layer occurs, the member might not securely be connected to the wiring layer. In this case, problems might occur that a sufficient connection strength cannot be guaranteed to cause disconnection and that a connection resistance increases to an inconvenient degree.

On the other hand, in the wiring structure of the present invention, as described above, a void in which any wiring layer is not present on an inner wall side of the connection hole is defined in the connection hole. Therefore, even when adjacent connection holes are formed and provided with the wiring layers having the above-mentioned constitution, respectively, insulation between the wiring layers (between the adjacent wires in the wiring pattern) can be secured along a distance between the connection holes. In addition, when the wiring layer is formed so as to broaden toward the end thereof, a large connection area can be secured in a connecting portion between the body to be wired and the wiring layer (i.e., an exposed surface of the body to be wired in the bottom portion of the connection hole). Therefore, even when the wiring layer causes the positional deviation from the body to be wired during the patterning of the wiring layer, the connection between them is sufficiently secured.

Furthermore, the wiring layer includes a portion in which a sectional area increases toward the body to be wired, and the spatial area (the void) where the inner wall of the connection hole does not come in contact with the wiring layer, in other words, the area where the wiring layer does not come in contact is defined from the opening end of the inner wall of the connection hole toward a bottom portion side thereof, a volume of the wiring layer is reduced as much as the void in the connection hole. Therefore, the whole wiring structure can be thinned. In consequence, an amount of wires is reduced, so that a wire resistance and a parasitic capacity can be lowered.

In addition, the void is defined between the inner wall of the connection hole and the wiring layer, whereby it becomes easy to form the upper ends tp of the via-hole electrode portion 23p having the steeple-like sectional shape as shown in FIG. 16A, and the function of relaxing the stress applied to the via-hole electrode portion 23p is further improved. Furthermore, the width of the wiring layer can be set to a value of a dimension of the connection hole or less, so that the width of the wiring layer can be controlled with a small tolerance, and the amount of the wires is further reduced. In consequence, the wire resistance and the parasitic capacity of the whole wiring structure are further reduced. In addition, the void is generated at least in the vicinity of the opening end of the connection hole during manufacturing of the wiring structure. Therefore, even if conductive foreign matters are mixed around the wiring layer, the matters can be trapped in this void, and an effect that short-circuit between the wiring layers due to the foreign matters can be prevented can be expected.

Here, the whole wiring layer may be received in the connection hole or protruded from the connection hole. In other words, the wiring layer may be provided so as to fill the connection hole with at least a part of the wiring layer, the whole wiring layer may be provided in an inner area of the connection hole, or the wiring layer may be provided so that a level of the upper surface of the wiring layer is lower or higher than that of the opening end (an open end) of the connection hole. In any case, the wiring layer may be provided so that at least a part of the upper surface thereof forms a concave shape and so that a side wall thereof including the edge portion of the concave portion does not come in contact with the inner wall of the connection hole. Moreover, it is preferable that the wiring layer forms a shape broadening toward the end thereof and that a width (a maximum width in a section parallel to an opening end surface) of the wiring layer in the opening end of the connection hole is set to be smaller than an opening width diameter (a maximum width of the opening end of the connection hole) of the connection hole.

Furthermore, it is more preferable that the wiring layer is provided so as to cover the whole exposed surface of the body to be wired which is exposed to the bottom portion of the connection hole. In this case, a decrease of a wire strength and a rise of a connection resistance caused by mixing of impurities in an interface between the wiring layer and the body to be wired are suppressed.

Moreover, a printed wiring board according to the present invention is preferably constituted by comprising the wiring structure of the present invention. In the printed wiring board, the wiring structures are arranged, each wiring structure comprising: an insulating layer provided with a connection hole; a body to be wired which is arranged in a lower portion or an inner portion of the insulating layer so that at least a part of the body to be wired is exposed to a bottom portion of the connection hole; and a wiring layer connected to the body to be wired in the connection hole, having a concave portion in at least a part of an upper surface thereof, and provided so that a side wall thereof including an edge portion of the concave portion does not come in contact with an inner wall of the connection hole.

In addition, a forming method of a wiring structure according to the present invention is a method for effectively forming a wiring structure of the present invention, comprising: an insulating layer forming step of forming an insulating layer on a body to be wired; a connection hole forming step of forming at least one connection hole in the insulating layer so that at least a part of the body to be wired is exposed; and a wiring layer connection step of connecting the body to be wired to a wiring layer in the connection hole, the wiring layer connection step being configured to form the wiring layer so that a concave portion is formed in at least a part of an upper surface of the wiring layer and so that a side wall thereof including an edge portion of the concave portion of the wiring layer does not come in contact with an inner wall of the connection hole.

According to a wiring structure of the present invention or the like, a wiring layer is disposed which is connected to a body to be wired in a connection hole and which has a concave portion in at least a part of an upper surface thereof and which is provided so that a side wall thereof including an edge portion of the concave portion does not come in contact with an inner wall of the connection hole, whereby even when a thermal stress is applied to the wiring layer, an inner stress of the wiring layer can be relaxed to sufficiently improve a connection property between the body to be wired and the wiring layer. In consequence, reliability of a wiring board or a device including the wiring structure can be improved.

### BRIEF DESCRIPTION OF THE DRAWINGS

[0094]
FIGS. 1A and 1B are a plan view and a sectional view schematically showing a main part of one example of a semiconductor-embedded substrate including a preferable embodiment of a wiring structure according to the present invention, respectively;
FIG. 2 is a step diagram showing one example of a procedure to manufacture a semiconductor-embedded substrate 1;
FIG. 3 is a step diagram showing the example of the procedure to manufacture the semiconductor-embedded substrate 1;
FIG. 4 is a step diagram showing the example of the procedure to manufacture the semiconductor-embedded substrate 1;
FIG. 5 is a step diagram showing the example of the procedure to manufacture the semiconductor-embedded substrate 1;
FIG. 6 is a step diagram showing the example of the procedure to manufacture the semiconductor-embedded substrate 1;
FIG. 7 is a step diagram showing the example of the procedure to manufacture the semiconductor-embedded substrate 1;
FIG. 8 is a step diagram showing the example of the procedure to manufacture the semiconductor-embedded substrate 1;
FIG. 9 is a step diagram showing the example of the procedure to manufacture the semiconductor-embedded substrate 1;
FIG. 10 is a step diagram showing the example of the procedure to manufacture the semiconductor-embedded substrate 1;
FIG. 11 is a step diagram showing the example of the procedure to manufacture the semiconductor-embedded substrate 1;
FIGS. 12A to 12F are sectional views showing a wiring layer in another embodiment of the wiring structure according to the present invention, respectively;
FIG. 13 is a step diagram showing another example of the procedure to form the wiring structure of the present invention;
FIG. 14 is a perspective view showing a schematic structure of a semiconductor device;
FIGS. 15A and 15B are a plan view and a sectional view showing one example of a conventional wiring structure, respectively;
FIGS. 16A and 16B are schematic sectional views schematically showing a wiring structure having a concave portion at an upper surface of a wiring layer according to the present invention and a wiring structure in which the upper surface of the wiring layer is flat, respectively;
FIG. 17 is a plan photograph showing one example of a wiring structure manufactured in a procedure similar to that shown in FIGS. 2 to 11;
FIG. 18A is a section photograph showing a section around a via-hole electrode portion 23a or 23b of the wiring structure shown in FIG. 17;
FIG. 18B is a section photograph showing the section around the via-hole electrode portion 23a or 23b of the wiring structure shown in FIG. 17;
FIG. 18C is a section photograph showing the section around the via-hole electrode portion 23a or 23b of the wiring structure shown in FIG. 17;
FIG. 19A is a sectional view showing a result of stress analysis simulation performed concerning the wiring structure of the present invention having the concave portion at the upper surface of the wiring layer; and
FIG. 19B is a sectional view showing a result of the stress analysis simulation performed concerning the wiring structure in which the upper surface of the wiring layer is flat.

### DESCRIPTION OF THE PREFERRED EMBODIMENT

An embodiment of the present invention will hereinafter be described in detail. It is to be noted that in the drawings, the same element is denoted with the same reference numeral, and redundant description is omitted. Moreover, it is assumed that upper, lower, left and right positional relations are based on a positional relation shown in the drawing, unless specified otherwise. Furthermore, a dimensional ratio of the drawing is not limited to a shown ratio. The following embodiment is an illustration for the description of the present invention, and it is not intended that the present invention is limited only to the embodiment. Furthermore, the present invention can variously be modified without departing from the scope thereof.

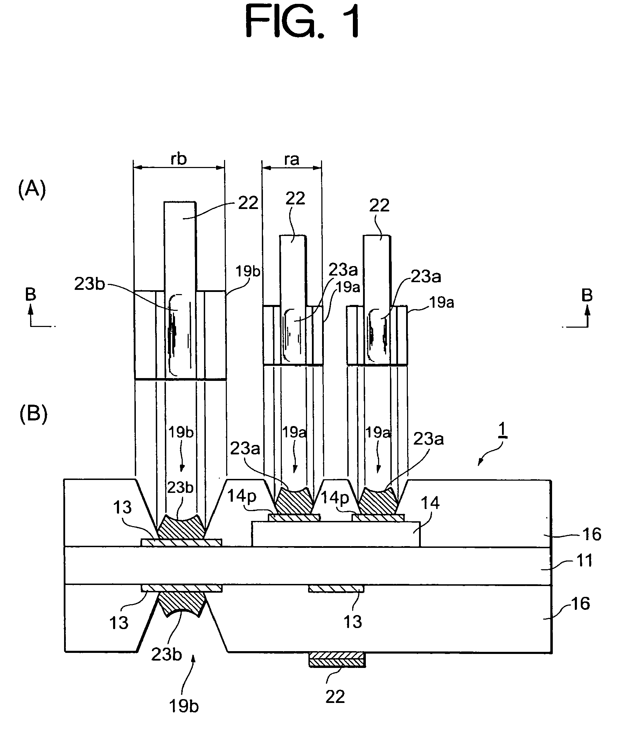

FIG. 1A is a plan view showing an outline of a main part of one example of a semiconductor-embedded substrate including one preferable embodiment of the wiring structure according to the present invention, and FIG. 1B is a sectional view cut along the B-B line of FIG. 1A.

In a semiconductor-embedded substrate 1 (a printed wiring board), conductive patterns 13 (bodies to be wired) are formed on opposite surfaces of a core substrate 11, and a semiconductor device 14 is arranged in a resin layer 16 laminated on the core substrate 11. The resin layer 16 is provided with via-holes 19a, 19b (connection holes) so that the conductive patterns 13 and bumps 14p (bodies to be wired) of the semiconductor device 14 arranged in a lower portion/an upper portion (a core substrate 11 side) and an inner portion of the resin layer are protruded or exposed from the resin layer 16. Further in the via-holes 19a, 19b, the bumps 14p and the conductive patterns 13 are connected to via-hole electrode portions 23a, 23b (both of them are wiring layers) of a conductive pattern 22, respectively.

The via-hole electrode portions 23a, 23b are provided with concave portions at upper surfaces of the via-hole electrode portions in sections thereof in the same manner as in the via-hole electrode portion 23p of the wiring structure P described above and shown in FIG. 16A. As shown in FIG. 1A, these concave portions are provided at plane areas in the via-holes 19a, 19b. The via-hole electrode portions 23a, 23b are provided so that side walls thereof including peripheral edges (edge portions) of the concave portions do not come in contact with inner walls of the via-holes 19a, 19b, and formed so as to include trapezoidal sectional portions as shown in the drawing. In other words, substantially upper half portions of the via-hole electrode portions are formed so as to broaden toward the ends thereof so that sectional areas thereof enlarge toward the conductive patterns 13 and the bumps 14p. The via-hole electrode portions come in contact with portions around bottom portions of the inner walls of the via-holes 19a, 19b, and do not come in contact with portions of the via-holes above the bottom portions on opposite sides of the via-hole electrode portion. A spatial area (a void) is defined between the inner wall of the via-hole 19a or 19b and the via-hole electrode portion 23a or 23b. Furthermore, side wall inclined surface ends of the via-hole electrode portions 23a, 23b are formed so as to abut on the side walls of the via-holes 19a, 19b.

The core substrate 11 performs a role of a base material which secures a mechanism strength of the whole semiconductor-embedded substrate 1, and there is not any special restriction on the core substrate, but, for example, a resin substrate or the like may be used. As a material of the resin substrate, it is preferable to use a material obtained by impregnating a core material constituted of glass cloth, resin cloth of Kevlar, aramid, liquid crystal polymer or the like, a porous sheet of a fluorine resin or the like with a thermosetting resin, a thermoplastic resin or the like, and it is preferable that the material has a thickness of about 20 µm to 200 µm. Moreover, for a purpose of homogenizing processing conditions as an application of a substrate to be subjected to laser processing, a coreless sheet material such as LCP, PPS, PES, PEEK or PI may be used.

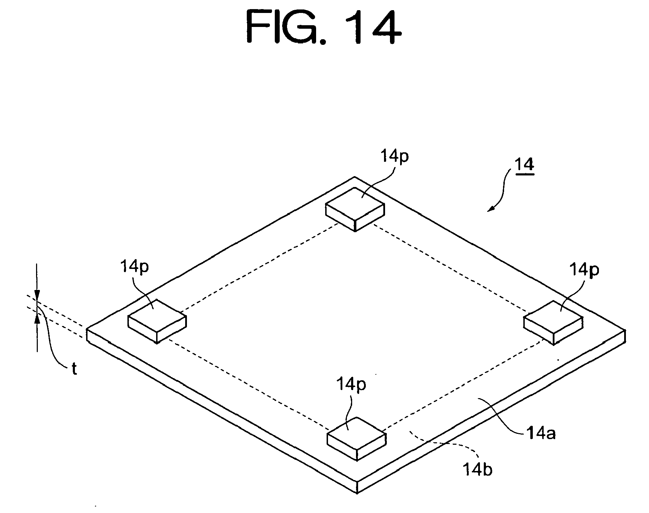

Here, the semiconductor device 14 is a semiconductor component such as a semiconductor IC (die) having a bare chip state. FIG. 14 is a perspective view showing a schematic structure of the semiconductor device 14. The semiconductor device 14 has a large number of land electrodes (not shown) and the bumps 14p bonded onto the electrodes on a substantially rectangular plate-like main surface 14a of the device. It is to be noted that in the drawing, the bumps 14p are displayed only at four corners, and display of the other bumps is omitted.

Moreover, there is not any special restriction on the semiconductor device, but a back surface 14b of the semiconductor device 14 is polished. In consequence, a thickness t (a distance from the main surface 14a to the back surface 14b) of the semiconductor device 14 is set to be smaller as compared with a usual semiconductor device, and set to, for example, preferably 200 µm or less, more preferably about 10 to 100 µm. On the other hand, to further thin the semiconductor device 14, it is preferable to subject the back surface 14b to a surface roughening treatment such as etching, a plasma treatment, laser irradiation, blast polishing, buff polishing or a chemical treatment.

It is to be noted that it is preferable that the polishing of the back surface 14b of the semiconductor device 14 is collectively performed with respect to a large number of semiconductor devices 14 in a wafer state, and then a wafer is separated into the individual semiconductor devices 14 by dicing. In a case where the wafer is cut and separated into the individual semiconductor devices 14 by the dicing before the semiconductor devices are polished and thinned, the back surfaces 14b can be polished in a state in which the main surfaces 14a of the semiconductor device 14 are covered with a resin or the like.

There is not any special restriction on a type of the bumps 14p, and examples of various types of bumps include stud bumps, plate bumps, plated bumps and ball bump. In the drawings, the plate bumps are shown.

When the stud bump is used as the bump 14p, the bump can be formed by wire bonding of silver (Ag), copper (Cu) or gold (Au). When the plate bump is used, the bump can be formed by plating, sputtering or evaporation. When the plated bump is used, the bump can be formed by the plating. When the ball bump is used, the bump can be formed by disposing a solder ball on the land electrode and then melting the ball, or printing a cream solder on the land electrode and then melting this solder. Alternatively, a conical or columnar bump formed by screen-printing a conductive material to cure this material, or a bump formed by printing, heating and sintering a nano-paste may be used.

There is not any special restriction on a type of metal usable in the bump 14p, and examples of the metal include gold (Au), silver (Ag), copper (Cu), nickel (Ni), tin (Sn), chromium (Cr), a nickel-chromium alloy and a solder. Among them, it is preferable to use copper. When copper is used as the material of the bump 14p, it is possible to obtain a high bonding strength with respect to the land electrode as compared with a case where, for example, gold is used, and reliability of the semiconductor device 14 is improved.

Moreover, a dimensional shape of the bump 14p can appropriately be set in accordance with an interval (a pitch) between the land electrodes, and when the pitch between the land electrodes is, for example, about 100 µm, a maximum width diameter of the bump 14p may be set to about 10 to 90 µm, and a height thereof may be set to about 2 to 100 µm. It is to be noted that with regard to the bumps 14p, a wafer may be diced, thereby cut and separated into the individual semiconductor devices 14, and then the bumps can be bonded to the respective land electrodes by use of a wire bonder.

The resin layers 16 are insulating layers which electrically insulate the conductive patterns 13 and the semiconductor devices 14 from the outside, and examples of a material for use in the resin layer include a unitary material of a vinyl benzyl resin, a polyvinyl benzyl ether compound resin, a bismaleimide triazine resin (BT resin), a polyphenylether (polyphenylene ether oxide) resin (PPE, PPO), a cyanate ester resin, an epoxy + active ester cured resin, a polyphenylene ether resin (polyphenylene oxaodor resin), a curing polyolefin resin, a benzocyclobutene resin, a polyimide resin, an aromatic polyester resin, an aromatic liquid crystal polyester resin, a polyphenylene sulfide resin, a polyether imide resin, a polyacrylate resin, a polyether ether ketone resin, a fluorine resin, an epoxy resin, a phenol resin or a benzoxazine resin; a material obtained by adding, to this resin, silica, talc, calcium carbonate, magnesium carbonate, aluminum hydroxide, magnesium hydroxide, an aluminum borate whisker, a potassium titanate fiber, alumina, a glass flake, a glass fiber, tantalum nitride, aluminum nitride or the like; a material obtained by adding, to this resin, metal oxide powder including at least one of metals such as magnesium, silicon, titanium, zinc, calcium, strontium, zirconium, tin, neodymium, samarium, aluminum, bismuth, lead, lanthanum, lithium and tantalum; a material obtained by blending this resin with a resin fiber such as a glass fiber or an aramid fiber; and a material obtained by impregnating glass cloth, an aramid fiber, nonwoven cloth or the like with this resin. The material can appropriately be selected for use from viewpoints of an electric property, a mechanical property, a water absorption property and a reflow resistance. It is to be noted that there is not any restriction on thickness of the resin layer 16, but the thickness is usually about 10 to 100 µm.

The via-holes 19a, 19b are connection holes provided through the resin layers 16 so that the conductive patterns 13 and the semiconductor device 14 are physically connected as the bodies to be wired to the conductive patterns 22, and the via-holes have such positions and depths that at least a part of the conductive patterns 13 and the bumps 14p of the semiconductor device 14 is exposed from the resin layers 16. That is, the conductive patterns 13 and the bumps 14p are provided so that at least a part of them is exposed to the bottom portions of the via-holes 19a, 19b.

There is not any special restriction on a forming method of the via-holes 19a, 19b, and a known method such as laser processing, etching processing or blast processing may be used. When the via-holes are formed by the laser processing, smear is generated, and hence it is preferable to perform a desmear treatment after the connection holes are formed.

The via-holes 19a, 19b may be formed into such a dimensional shape so that the conductive patterns 13 and the bumps 14p can physically be connected to the via-hole electrode portions 23a, 23b in the via-holes, the shape of the hole can appropriately be determined in consideration of a depth of the hole, targeted mounting density and connection stability and the like, and examples of the hole include a cylindrical hole having an opening end diameter of about 5 to 200 µm and a square tubular hole having a maximum diameter of about 5 to 200 µm. The hole does not have to be straight tubular, and in the drawing, inverted pyramid-like holes are shown as one example. Such via-holes 19a, 19b in which a width diameter gradually increases from the bottom portion of the hole toward the opening end can be formed by, for example, etching processing, blast processing or the like.

Moreover, the conductive pattern 22 is a wiring layer which is electrically connected to the conductive pattern 13 and the bump 14p as the bodies to be wired. There is not any special restriction on a material of this conductive pattern 22, and a conductor such as a metal generally for use in a wire may be used, and the material may be the same as or different from that of the conductive pattern 13 or the bump 14p. To form the conductive pattern 22, when an etching step is included, an etchant (an etching solution for wet etching, etchant particles for dry etching or the like) can appropriately be selected for use so that the etchant does not etch the material of the conductive pattern 13 or the bump 14p.

Furthermore, there is not any special restriction on the thickness of the conductive pattern 22, but when the thickness is excessively small, the connection stability lowers, and hence the thickness is usually set to about 5 to 70 µm. When the thickness of the conductive pattern 22 is set to be smaller than the depth of the via-holes 19a, 19b as in the present embodiment, in via-hole connecting portions, the conductive pattern 22 (the via-hole electrode portions 23a, 23b) is received in the via-holes 19a, 19b, and a wire height can be reduced to contribute to thinning. Moreover, an amount of wires can be reduced to lower a wire resistance and a parasitic capacity, and the connection stability can preferably be improved.

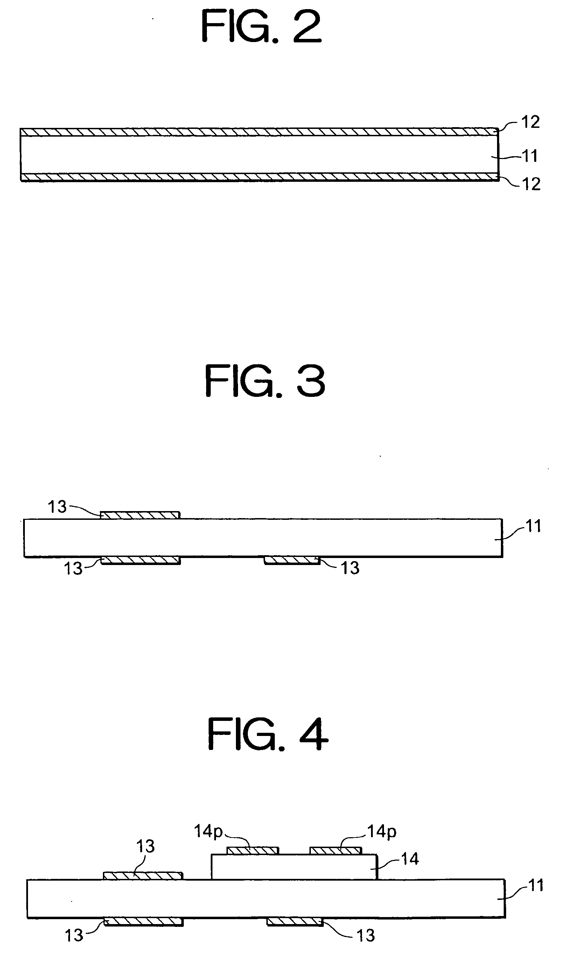

Next, one example of a manufacturing method of the semiconductor-embedded substrate 1 will be described with reference to the drawings. FIGS. 2 to 11 are step diagrams showing one example of a procedure to manufacture the semiconductor-embedded substrate 1.

First, copper foils 12 are attached to opposite surfaces of the core substrate 11 to prepare a resin substrate provided with the copper foils on the opposite surfaces thereof (FIG. 2). Here, the copper foils 12 form the conductive patterns 13. When an electrolytic copper foil manufactured for the printed wiring board (copper dissolved and ionized in an aqueous copper sulfate solution is continuously electrodeposited with an electrodeposition roll to form the copper foil) or a rolled copper foil is used, fluctuations of the thickness of the copper foil can remarkably be reduced. If necessary, the thickness of the copper foil 12 may be adjusted with a technique such as sweeping.

Subsequently, the copper foils 12 provided on the opposite surfaces of the core substrate 11 are selectively removed by photolithography and etching to form the conductive patterns 13 on the core substrate 11 (FIG. 3). At this time, the copper foil 12 present at a predetermined area on the core substrate 11 is entirely removed to secure a mounting area of the semiconductor device 14.

Subsequently, the semiconductor device 14 is disposed at the predetermined area on the core substrate 11 in a so-called face-up state (FIG. 4). At this time, it is preferable to temporarily fix the semiconductor device 14 on the core substrate 11 by use of an adhesive or the like.

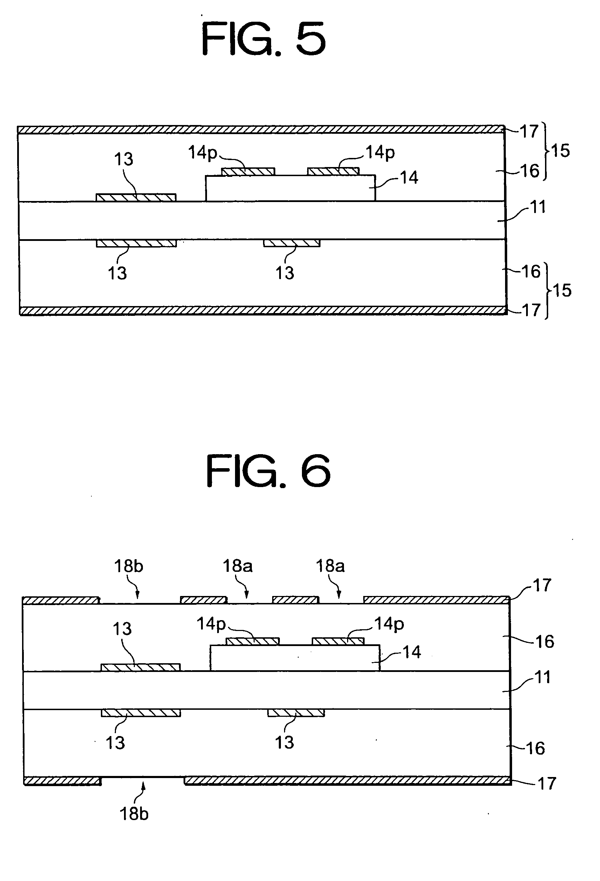

Furthermore, resin sheets 15 each provided with a copper foil on one surface thereof are attached to the opposite surfaces of the core substrate 11 on which the semiconductor device 14 has been disposed (FIG. 5). In the present manufacturing example, the resin sheet 15 provided with the copper foil on the one surface thereof is a sheet in which a copper foil 17 is attached to one surface of a thermosetting resin sheet 16 made of an epoxy resin of B stage. Such resin sheets 15 each provided with the copper foil on the one surface thereof are prepared, and resin surfaces of the sheets are attached to the opposite surfaces of the core substrate 11, and then hot-pressed to integrate the resin sheets 15 each including the copper foil on one surface thereof with the core substrate 11. In consequence, the semiconductor device 14 is embedded in the printed wiring board, and the thermosetting resin sheets 16 constitute the resin layers 16 (an insulating layer forming step).

Subsequently, the copper foil 17 provided on the surface of the resin layer 16 is selectively removed by conformal processing to form mask patterns for forming the via-holes 19a, 19b (FIG. 6). It is preferable to perform the conformal processing by photolithography and etching because highly precise fine processing can be realized. It is to be noted that there is not any special restriction on an opening width diameter of the mask pattern, but it is preferable to set the opening width diameter to about 10 to 200 µm, and it is also preferable to increase the opening width diameter in accordance with the depth of the via-holes 19a, 19b. In consequence, opening patterns 18a are formed right above the bumps 14p of the semiconductor device 14, and an opening pattern 18b is formed right above the conductive pattern 13 formed on the surface of the core substrate 11.

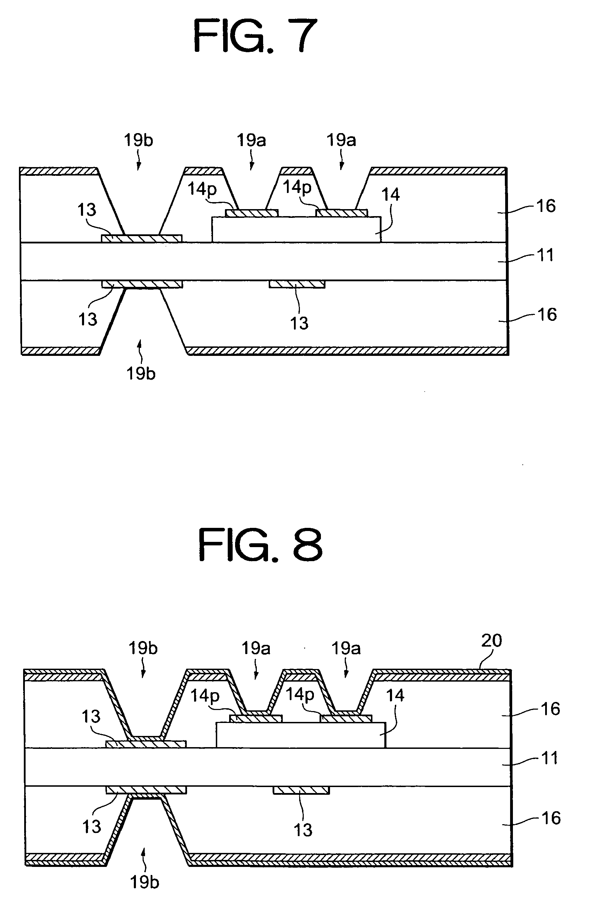

Then, the via-holes 19a, 19b are formed by the sand blast treatment using the copper foil 17 subjected to the conformal processing as a mask (FIG. 7). In the sand blast treatment, blast particles such as non-metal particles or metal particles are projected to grind the body to be wired, but metal layers such as the bumps 14p and the conductive pattern 13 can be provided right under the opening patterns 18a, 18b to selectively form the via-holes having different depths. In this case, to form the via-holes 19a, the bumps 14p function as stoppers, so that the semiconductor device 14 can be prevented from being damaged by the blast particles. To form the via-hole 19b, the conductive pattern 13 of an inner layer functions as a stopper, and hence the via-hole 19b can be inhibited from being bored deeper. In this manner, a structure is formed in which the via-holes 19a, 19b are non-through holes and in which the bumps 14p or the conductive patterns 13 are exposed to the bottom portions of the via-holes 19a, 19b, respectively (a connection hole forming step).

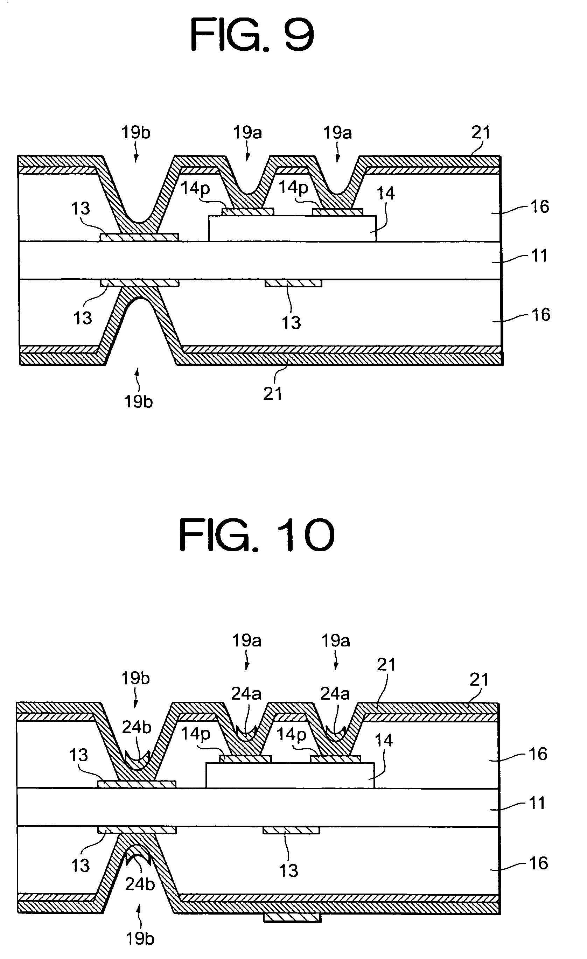

Subsequently, a conductive underlayer 20 is formed substantially over the whole exposed surfaces of the via-holes 19a, 19b including inner wall surfaces of the via-holes 19a, 19b (FIG. 8). It is preferable to use an electroless plating (chemical plating) process as a forming method of the conductive underlayer 20, but a sputtering process, an evaporation process or the like may be used. The conductive underlayer 20 performs a role of an underlayer metal (or a seed layer) for electrolytic (electric) plating to be subsequently performed, and a thickness of the conductive underlayer may be very small, and can appropriately be selected from a range of, for example, several ten nanometers to several micrometers. Subsequently, a conductive metal is grown from the conductive underlayer 20 by the electric plating process (FIG. 9). In consequence, a conductive layer 21 including the conductive underlayer 20 is formed on the inner wall surfaces of the via-holes 19a, 19b. At this time, plating conditions such as a composition of a plating bath for use in the electrolytic plating, a current density, an electrolysis time, stirring method and speed, and a type of an additive are appropriately adjusted to form concave portions (recesses) at the conductive layer 21 in the centers of the via-holes 19a, 19b.

Afterward, by the photolithography, resist layers 24a, 24b are formed on areas which form the conductive pattern 22 of the conductive layer 21 (FIG. 10). Here, in order to form the via-hole electrode portions 23a, 23b of the conductive pattern 22 so that the via-hole electrode portions do not come in contact with the inner walls of the via-holes 19a, 19b, the resist layers 24a, 24b are formed so that widths of the resist layers 24a, 24b in the via-holes 19a, 19b are smaller than upper opening width diameters ra, rb of the via-holes.

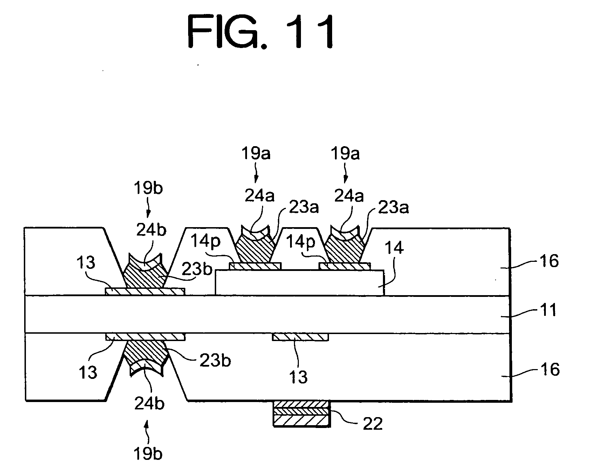

Subsequently, etching is performed using the resist layers 24a, 24b as etching masks to selectively remove the conductive layer 21 other than the wiring pattern, whereby the conductive pattern 22 (the via-hole electrode portions 23a, 23b) is formed (FIG. 11: a wiring layer connection step). At this time, an etching speed (an etch rate) of the conductive layer 21 around the mask is lower than that of another portion, and hence upper portions of the via-hole electrode portions 23a, 23b as the resultant wiring layers are formed into a shape which broadens toward the end thereof.

Then, the resist layers 24a, 24b on the conductive pattern 22 are removed using a peeling solution to obtain the semiconductor-embedded substrate 1 having a constitution shown in FIG. 1.

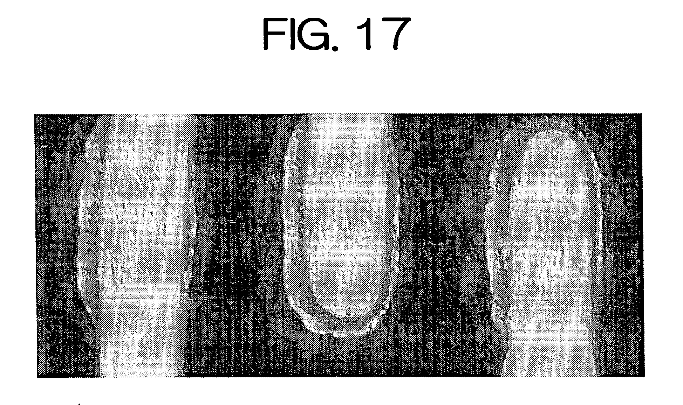

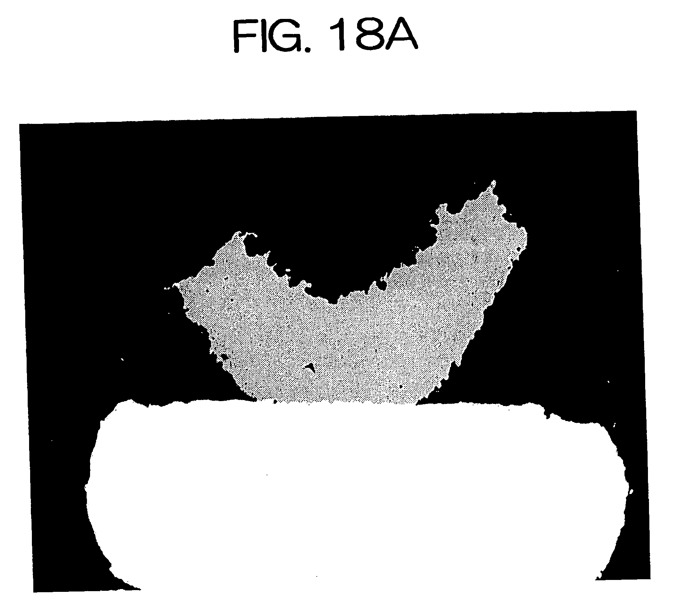

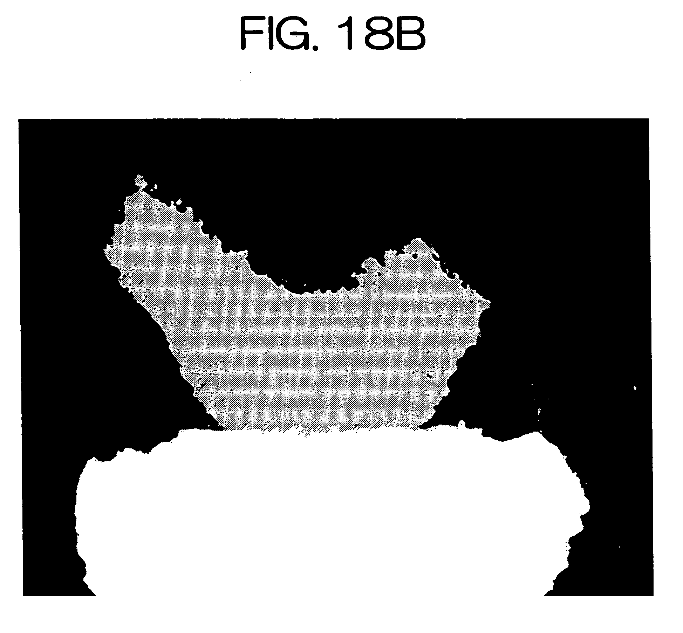

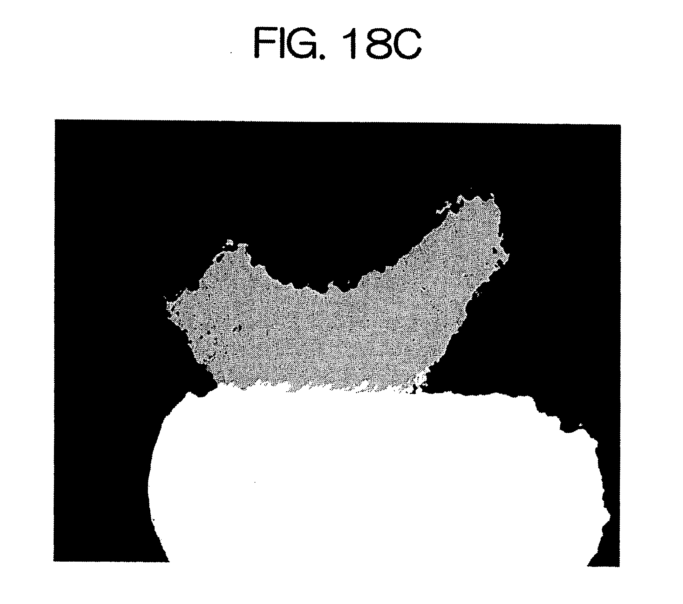

Here, FIG. 17 is a plan photograph (a photograph corresponding to a plan view shown in FIG. 1A) showing one example of a wiring structure manufactured in a procedure similar to the procedure described above and shown in FIGS. 2 to 11, and FIGS. 18A to 18C are section photographs (a photograph corresponding to a portion around the via-hole electrode portion 23a or 23b in the sectional view shown in FIG. 1B) showing the portion around the via-hole electrode portion 23a or 23b of the wiring structure shown in FIG. 17. It is to be noted that FIGS. 18A to 18C show that a contrast of an actually photographed image has been adjusted in order to emphasize contour shapes of the via-hole electrode portion and the bump connected thereto. With regard to the via-hole electrode portion 23a or 23b shown in these photographs, the upper surfaces thereof have an entirely recessed shape, and it has been microscopically confirmed that micro protrusion-like unevenness is formed on the surface of the via-hole electrode portion.

According to the semiconductor-embedded substrate 1 including the wiring structure of the present invention having such a constitution, when the via-hole electrode portions 23a, 23b are subjected to heating and cooling treatments in manufacturing steps and inspection steps, a thermal stress is applied to inner portions of the via-hole electrode portions 23a, 23b owing to expansion and contraction thereof. Especially in contact interface areas between the via-hole electrode portions 23a, 23b and the bumps 14p and conductive patterns 13, such a stress as to move the via-hole electrode portions 23a, 23b with respect to the bumps 14p and the conductive patterns 13 might be generated owing to differences of a thermal expansion ratio and a thermal contraction ratio between them.

In this case, the concave portions are formed at the upper surfaces of the via-hole electrode portions 23a, 23b, the upper side walls are formed as inclined surfaces, and upper ends including peripheral edges of the respective concave portions do not come in contact with the inner walls of the via-holes 19a, 19b. Therefore, a thermal strain generated in the via-hole electrode portion is relaxed so as to be so-called absorbed in the concave portions in the same manner as in the via-hole electrode portion 23p shown in FIG. 16A. A stress functions so as to move (peel) the via-hole electrode portions 23a, 23b from the bumps 14p and the conductive patterns 13 in the interface areas between the via-hole electrode portions 23a, 23b and the bumps 14p and conductive patterns 13, but a degree of the stress can remarkably be reduced as compared with the via-hole electrode portion 23q having a flat upper surface as shown in FIG. 16B.

Moreover, the via-hole electrode portions 23a, 23b include portions in which the sectional areas increase from the peripheral edges (the edge portions) of the upper surface concave portions toward the bumps 14p and the conductive patterns 13, and the upper side walls are formed as the inclined surfaces. Therefore, the upper ends forming steeple-like sections are easily formed, and a relaxing function of the stress applied to the via-hole electrode portions 23a, 23b is more easily obtained owing to the upper ends together with the upper surface concave portions.

Furthermore, diameters of the via-holes 19a, 19b are gradually increased from bottom walls thereof toward the upper openings, and the via-hole electrode portions 23a, 23b include portions in which the sectional areas increase from portions (the bottom walls of the via-holes 19a, 19b, that is, the exposed surfaces of the bumps 14p and the conductive patterns 13) connected to the bumps 14p and the conductive patterns 13 toward the upper openings of the via-holes 19a, 19b. Therefore, the stresses applied to the interface areas between the via-hole electrode portions 23a, 23b and the bumps 14p and conductive patterns 13 are easily diffused along the bottom side walls (i.e., the inner walls of the bottom portions of the via-holes 19a, 19b) of the via-hole electrode portions 23a, 23b, and the inner stresses of the via-hole electrode portions 23a, 23b can further be relaxed.

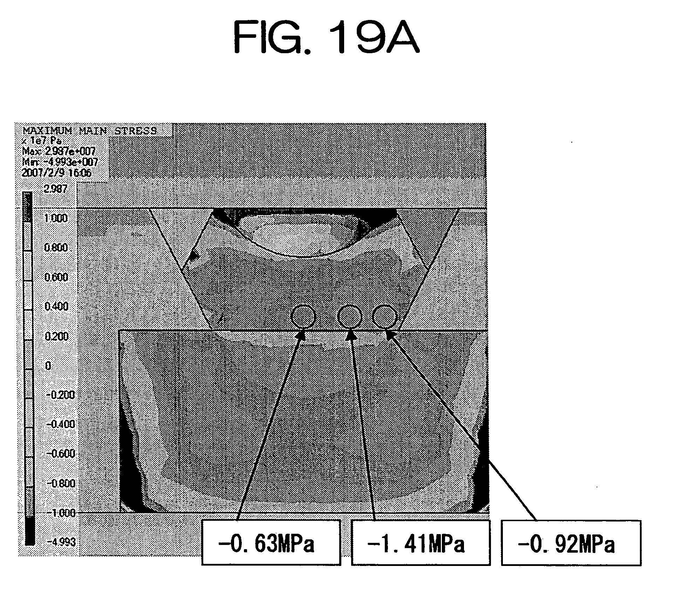

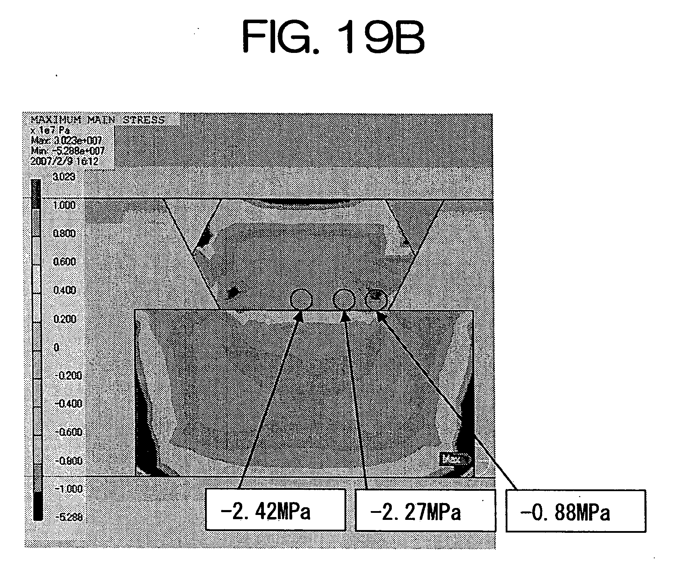

Here, FIGS. 19A and 19B are sectional views showing a result of stress analysis simulation performed concerning one example of the wiring structure of the present invention having the concave portions at the upper surfaces of the wiring layers (corresponding to the via-hole electrode portions 23a, 23b) and the wiring structure in which the upper surface of the wiring layer is flat, respectively (the respective structures correspond to those shown in FIGS. 16A and 16B, with the proviso that the side wall of the wiring layer including the edge portion of the concave portion does not come in contact with the via-hole). Maximum main stresses generated at a time when these wiring structures are heated from 25°C to 100°C are visualized in contour of a gray scale (actual output results are displayed in color).

In both the drawings, numeric values surrounded with quadrangular frames indicate calculated values of a stress on a wiring layer side (in the drawing, a portion roughly shown with a black circle) in the interface area between the wiring layer and the body to be wired. It is indicated that the larger an absolute value of the stress is, the larger a value of an inner stress of the wiring layer becomes. It has been confirmed from these results that in the wiring structure including the wiring layer having the concave portion at the upper surface thereof as shown in FIG. 19A, the inner stress which functions in the contact interface area between the wiring layer and the body to be wired can sufficiently be reduced as compared with the wiring structure in which the wiring layer does not have any concave portion at the upper surface thereof as shown in FIG. 19B. It is to be noted that a wiring layer having a shape similar to that of the via-hole electrode portion 23q which did not have any void defined between the via-hole electrode portion and the inner wall of the via-hole as shown in FIG. 16B was subjected to the stress analysis simulation similar to that of FIGS. 19A and 19B. As a result, it has been found that the value of the inner stress tends to be large as compared with the wiring layer shown in FIG. 19B.

Therefore, in the semiconductor-embedded substrate 1, it is possible to reduce such stresses as to function so as to move (peel) the via-hole electrode portions 23a, 23b from the conductive patterns 13 and the bumps 14p in the contact interface areas between the conductive pattern 13 and the via-hole electrode portion 23a and between the bump 14p and the via-hole electrode portion 23b, whereby a connection property between them can be improved, and a sufficient connected state between them can be held with an elapse of time.

Moreover, the concave portion is formed in at least a part of the upper surface of the via-hole electrode portion 23a or 23b, so that the surface area of the upper surface enlarges as compared with a case where the upper surface is flat. Therefore, when upper structures of a resin or the like (a solder resist or the like) are laminated on the upper portions of the via-hole electrode portions 23a, 23b, contact areas between the upper structures and the via-hole electrode portions 23a, 23b enlarge, and the connection property between them can be improved. Moreover, at least a part of the upper surface of the via-hole electrode portion 23a or 23b has the concave portion, so that a structure is formed in which the edge portions of the concave portions protrude into the upper structure of the resin or the like in the layer above the concave portions. Owing to a so-called anchor effect, a bonding property (a fixing force of the resin or the like) between the upper structure and the via-hole electrode portion can further be improved.

Furthermore, in the via-holes 19a, 19b, the via-hole electrode portions 23a, 23b include portions in which the sectional areas gradually increase toward the conductive patterns 13 and the bumps 14p, respectively, and spatial areas are defined where the inner walls of the via-holes 19a, 19b do not come in contact with the via-hole electrode portions 23a, 23b, so that insulation is secured along a distance between the adjacent via-holes 19a and 19a and that between the via-holes 19a and 19b. Therefore, while securely maintaining the insulation between the adjacent via-holes 19a and 19a and between the via-holes 19a and 19b, the conductive patterns 13 and the bumps 14p can securely be connected to the via-hole electrode portions 23a, 23b. In consequence, highly dense mounting on the semiconductor-embedded substrate 1 can be realized owing to the reduction of the pitch between the via-holes 19a and 19b.

In addition, the via-hole electrode portions 23a, 23b are formed so as to broaden toward the ends thereof, whereby a large contact area can be secured in connection portions between the conductive patterns 13 and bumps 14p and the via-hole electrode portions 23a, 23b (exposed surfaces of the conductive patterns 13 and the bumps 14p in the bottom portions of the via-holes 19a, 19b). Therefore, even if the via-hole electrode portions 23a, 23b cause positional deviations from the conductive patterns 13 and the bumps 14p during the patterning of the via-hole electrode portions 23a, 23b, the connection between them can sufficiently be secured. Therefore, sufficient connection strengths between the via-hole electrode portions 23a, 23b and the conductive patterns 13 and bumps 14p can be guaranteed, whereby disconnection and a rise of a connection resistance can be suppressed, and reliability and productivity of a product can be improved.

Furthermore, the via-hole electrode portions 23a, 23b are formed so as to include portions in which the sectional areas increase toward the conductive patterns 13 and the bumps 14p, and the spatial areas (the voids) are defined where the inner walls of the via-holes 19a, 19b do not come in contact with the via-hole electrode portions 23a, 23b. Therefore, a volume of the wiring layer can be reduced as much as the void, and the whole wiring structure can be thinned. The amount of the wires is reduced in this manner, and hence the wire resistance and the parasitic capacity can be lowered.

In addition, the voids are defined between the inner walls of the via-hole electrode portions 23a, 23b and the conductive patterns 13 and bumps 14p, whereby widths of the via-hole electrode portions 23a, 23b can be set to values of dimensions of the via-holes 19a, 19b or less. In consequence, the widths of the via-holes 19a, 19b can be controlled with tolerances, and the amount of the wires can further be reduced to further reduce the wire resistance and the parasitic capacity of the whole wiring structure. During manufacturing of the wiring structure, the voids are generated around the opening ends in at least the via-holes 19a, 19b. Therefore, even if conductive foreign matters or the like are mixed around the via-hole electrode portions 23a, 23b, the foreign matters can be trapped in these voids, and short-circuit between the via-hole electrode portions 23a and 23b due to the foreign matters can be prevented.

Moreover, the voids are defined between the inner walls of the via-hole electrode portions 23a, 23b and the conductive patterns 13 and bumps 14p, so that a close contact property between a further laminate material laminated on the resin layer 16 by a build-up process or the like, a solder resist or the like and the insulating layer 16 is improved by the anchor effect. Furthermore, the via-hole electrode portions 23a, 23b have the concave portions at the upper surfaces thereof, so that the edge portions (the upper ends) of the concave portions (the recesses) are arranged so as to protrude into the upper structure of the resin that might be formed on the upper layer of the via-hole electrode portions, and a bonding property (the fixing force of the resin or the like) between the via-hole electrode portions and the upper structure is also further improved by the anchor effect.

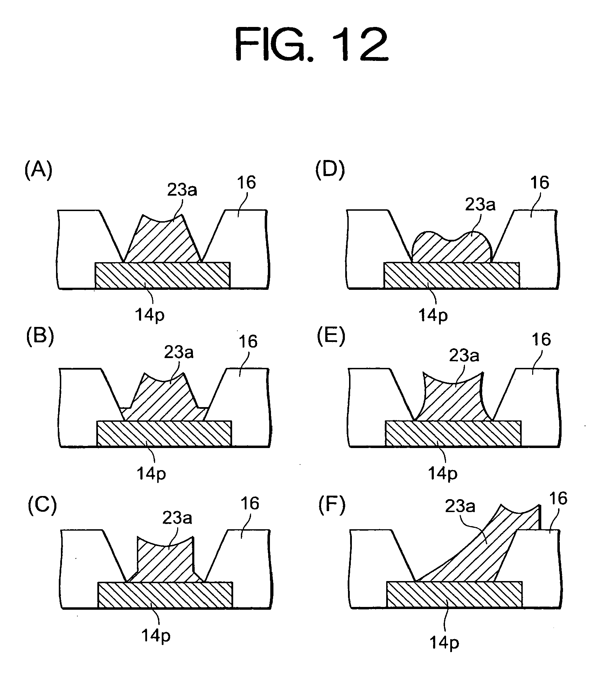

Here, other examples provided with the via-hole electrode portion 23a having such a shape are shown in FIGS. 12A to 12F. FIGS. 12A to 12E are sectional views showing a configuration in which the via-hole electrode portion 23a has a concave portion at an upper surface thereof, and does not come in contact with an inner wall of a connection hole on opposite sides of a section of the via-hole electrode portion in a width direction thereof, to define a void.
FIG. 12F is a sectional view showing a configuration in which the via-hole electrode portion 23a has a concave portion at an upper surface thereof, and does not come in contact with an inner wall of a connection hole only on one side of a section of the via-hole electrode portion in a width direction thereof, to define a void.

Moreover, the via-hole electrode portions 23a, 23b are provided so as to cover substantially the whole exposed surfaces of the conductive patterns 13 and the bumps 14p in the bottom portions of the via-holes 19a, 19b, so that an etching solution for use in forming the via-hole electrode portions 23a, 23b and other impurities can effective be prevented from penetrating the connection interfaces between the via-hole electrode portions 23a, 23b and the conductive patterns 13 and bumps 14p, and a sufficient wire strength can be secured. Therefore, reliability of electric connection in the via-hole connecting portions can be improved, and the connection resistance can be reduced.

It is to be noted that in the configuration shown in FIG. 12B, the whole periphery of the vicinity of the bottom portion of the inner wall of the via-hole 19a or 19b comes in contact with the via-hole electrode portion 23a or 23b, and hence the whole exposed surfaces of the conductive patterns 13 and the bumps 14p are further securely covered. Not only the conductive patterns 13 and the bumps 14p but also the side walls of the via-holes 19a, 19b are covered with the via-hole electrode portions 23a, 23b, so that corrosion of a conductor can be prevented even in a case where penetration of water or the like is generated from above.

With regard to this respect, heretofore, it has been supposed that when an opening end of a connection hole is not completely covered with a wiring layer, reliability of electric connection lowers or resistance of a connecting portion increases. To prevent these problems, there has been a tendency that pattern design to set a width of the wiring layer to be larger than a bore diameter of the connection hole is employed so that the opening end of the connection hole can completely be covered even in a case where a positional deviation from the connection hole is caused during forming of the wiring layer.

However, according to findings of the present inventors, it has been clarified that the reliability and the resistance of the electric connection in the via-hole connecting portion are influenced by coverage of the exposed surface of the body to be wired at the bottom wall of the connection hole, not by coverage of the opening end of the connection hole.

To cover the whole exposed surface of the body to be wired, for example, in a case where the wiring layer is formed by a subtractive process as in the above manufacturing example, when the conductive layer 21 other than the wiring pattern is selectively removed by etching (FIG. 11), etching treatment conditions may be adjusted so that the etching is stopped before the conductive layer 21 is removed up to the conductive pattern 13 and the bump 14p. Moreover, to cover the whole exposed surface of the body to be wired with the wiring layer even in a case where deviation is generated in a forming position of the wiring layer, etching treatment conditions such as an etching amount may appropriately be set in consideration of the assumed positional deviation.

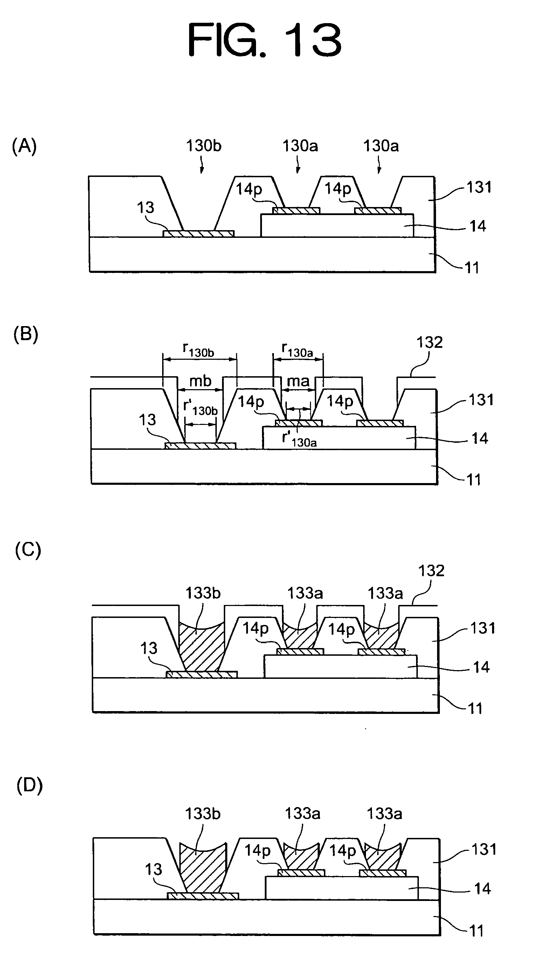

Moreover, in a case where a wire is formed by an additive process described later and shown in FIG. 13, when a mask layer 132 is formed on a portion other than a wiring pattern (FIG. 13B), opening widths ma, mb of the mask layer 132 may be set to be larger than width diameters r'₁₃₀ₐ, r'_{130b} (width diameters of bottom walls of via-holes) of exposed surfaces of bodies to be wired. Furthermore, to cover the whole exposed surfaces of the bodies to be wired with a wiring layer even in a case where deviation is generated in a forming position of the wiring layer, the opening widths ma, mb of the mask layer 132 may be set to be larger than the width diameters r'₁₃₀ₐ, r'_{130b} of the exposed surfaces of the bodies to be wired so as to include an assumed position deviation allowance.

Next, as another example to form the wiring structure according to the present invention, one example of a forming method of a wiring layer by use of the additive process (a method for selectively forming the wiring layer on a wiring pattern portion) will be described with reference to the drawings. FIGS. 13A to 13D are step diagrams showing another example of the procedure to form the wiring structure of the present invention.

First, there is prepared a multilayer printed wiring board having an insulating layer 131 provided with connection holes 130a, 130b formed so that a part of an upper surface of an inner wiring layer as a body to be wired is exposed (FIG. 13A).

Subsequently, the mask layer 132 constituted of a photo resist is formed on a portion other than a wiring pattern (FIG. 13B). In this case, the opening widths ma, mb of the mask layer 132 are set to be smaller than upper opening width diameters r₁₃₀ₐ, r_{130b} of the connection holes 130a, 130b so that both side surfaces of the wiring layer do not come in contact with upper inner walls of the connection holes. Subsequently, electroless plating is performed, wiring layers 133a, 133b each having a concave portion at an upper surface thereof are formed (FIG. 13C), and then the mask layer 132 on the wiring pattern is removed using a peeling solution, whereby the wiring layers 133a, 133b are formed so that a void including an opening end of the connection hole is defined between both the inner walls of the connection hole (FIG. 13D: a wiring layer connection step).

Even in a semiconductor-embedded substrate having the wiring structure obtained in this manner, function and effect similar to those produced by the semiconductor-embedded substrate 1 shown in FIG. 1 can be obtained.

It is to be noted that as described above, the present invention is not limited to the above embodiment, and can variously be modified without changing the scope. For example, in the wiring structure of the present invention, the whole upper surfaces of the via-hole electrode portions 23a, 23b do not have to form a concave shape, the concave portion may be formed at a part of the upper surface, and a section of the concave portion may not be horizontally symmetric. Furthermore, the shape of the concave portion of the upper surface of the via-hole electrode portion 23a or 23b is not limited to a mortar-like sectional shape, and may be a rectangular shape or an inverted trapezoidal shape. In addition, as shown in FIGS. 18A to 18C, the upper surface of the via-hole electrode portion 23a or 23b may be provided with micro protrusion-like unevenness. In this case, owing to the anchor effect of micro protrusions, a bonding property between the via-hole electrode portion and the upper layer is preferably further improved. In addition, the via-hole electrode portions 23a, 23b may protrude from opening levels of the via-holes 19a, 19b.

Moreover, the present invention is not limited to a single-layer structure in which the wiring layer is an uppermost layer, and may be applied to a multilayer structure obtained by a known build-up process employed in manufacturing a multilayer printed wiring board. In this case, the voids defined between the via-holes 19a, 19b and the via-hole electrode portions 23a, 23b shown in FIG. 1 may be filled with the insulating layer formed on the upper portions of the voids. The bodies to be wired are not limited to the conductive pattern 13 and the bump 14p of the semiconductor device, and all targets to be wired by the wiring layer, for example, electrodes of electronic components such as a resistor and a capacitor are included in the bodies to be wired of the present invention.

Furthermore, in the wiring structure of the present invention, the positional relation between the body to be wired connected to the wiring layer and another component or the like is not limited to a case where the body to be wired and the other component are positioned on separate planes in the same resin layer 16, and any configuration may be used in which they are positioned on the same plane or the separate planes in the same layer or in separate layers.

In addition, the conductive pattern 22 as the wiring layer may be a configuration in which the pattern does not come in contact with the inner walls of the via-holes 19a, 19b only on one side of the wiring layer in the width direction thereof, that is, a configuration in which the void is defined only on one side. From a viewpoint of securing of insulation, it is preferable that the pattern does not come in contact with the inner walls of the connection holes on the opposite sides of the wiring layer in the width direction thereof.

Moreover, a sectional shape of the via-hole electrode portions 23a, 23b is not limited to a hexagonal shape shown in the drawing, the sectional shape as a whole may broaden toward the end thereof so that the sectional area increases toward the body to be wired, and gaps including the opening ends of the via-holes 19a, 19b do not have to be defined between the inner walls of the via-holes 19a, 19b and the side walls of the via-hole electrode portions 23a, 23b. In addition, the upper surfaces of the via-hole electrode portions 23a, 23b as a whole do not have to be parallel to a substrate surface, and may be, for example, inclined. Furthermore, the inclined surfaces of the side wall upper portions of the via-hole electrode portions 23a, 23b do not have to be formed over the whole peripheral edges of the concave portions, and may be provided on at least a part of the peripheral edge of the concave portion.

Furthermore, in the above-mentioned manufacturing example, the widths of the resist layers 24a, 24b are adjusted to form the wiring layer so as to define the voids at the inner wall upper portions of the via-holes 19a, 19b as the connection holes in the forming step of the wiring layer. However, the wiring layer is once formed, and then a post-step of trimming a contact portion between the wiring layer and the inner wall of the connection hole by laser irradiation may be performed. From a viewpoint of simplification of the steps, it is preferable to directly form the wiring layer which does not come in contact with at least a part of the inner wall of the connection hole without separately performing the post-step. Moreover, in the above manufacturing examples, the methods using the subtractive process and the additive process have been described as the forming method of the wiring layer, but a semi-additive process or the like may be used. Furthermore, to form the via-hole electrode portions 23a, 23b, a film having a flat upper surface is once formed by electrolytic plating or electroless plating, and then a part of the upper surface may be subjected to etching or the like to form the concave portion.

As described above, according to a wiring structure, a forming method of the wiring structure and a printed wiring board of the present invention, a connection property of a body to be wired and a wiring layer connected to the member can sufficiently be improved, whereby reliability of a wiring board or a device including the wiring structure can be improved. Therefore, the present invention can broadly and effectively be used in an apparatus, a unit, a system or a device in which an active component such as a semiconductor device and/or a passive component such as a resistor or a capacitor are embedded and which is required to be miniaturized and have a high performance.

## Claims

1. A wiring structure comprising:
an insulating layer provided with a connection hole;
a body to be wired which is arranged so that at least a part of the body to be wired is exposed to a bottom portion of the connection hole; and
a wiring layer connected to the body to be wired in the connection hole, having a concave portion in at least a part of an upper surface thereof, and provided so that a side wall thereof including an edge portion of the concave portion does not come in contact with an inner wall of the connection hole.

2. The wiring structure according to claim 1, wherein the wiring layer includes a portion in which a sectional area increases from the edge portion of the concave portion toward the body to be wired.

3. The wiring structure according to claim 1, wherein the wiring layer includes a portion in which a sectional area increases from a portion connected to the body to be wired toward an opening of the connection hole.

4. The wiring structure according to claim 1, wherein the wiring layer is provided so as to define a spatial area where at least a part of the inner wall of the connection hole does not come in contact with the wiring layer.

5. The wiring structure according to claim 1, wherein a width of an upper end of the wiring layer is set to be smaller than an opening width diameter of the connection hole.

6. The wiring structure according to claim 1, wherein the wiring layer is provided so as to cover the whole exposed surface of the body to be wired which is exposed to the bottom portion of the connection hole.

7. A printed wiring board in which wiring structures are arranged, each wiring structure comprising:
an insulating layer provided with a connection hole; a body to be wired which is arranged in a lower portion or an inner portion of the insulating layer so that at least a part of the body to be wired is exposed to a bottom portion of the connection hole; and a wiring layer connected to the body to be wired in the connection hole, having a concave portion in at least a part of an upper surface thereof, and
provided so that a side wall thereof including an edge portion of the concave portion does not come in contact with an inner wall of the connection hole.

8. A method for forming a wiring structure, comprising:
an insulating layer forming step of forming an insulating layer on a body to be wired;
a connection hole forming step of forming at least one connection hole in the insulating layer so that at least a part of the body to be wired is exposed; and
a wiring layer connection step of connecting the body to be wired to a wiring layer in the connection hole,
the wiring layer connection step being configured to form the wiring layer so that a concave portion is formed in at least a part of an upper surface of the wiring layer and so that a side wall thereof including an edge portion of the concave portion of the wiring layer does not come in contact with an inner wall of the connection hole.
